# EUROPEAN PATENT APPLICATION

(11) **EP 4 556 727 A1**
(43) Date of publication of application: **21.05.2025**
(21) Application number: 23919481.4
(22) Date of filing: 07.12.2023
(51) Int. Cl.: F16C 11/04

(54) **SLIDING MECHANISM AND FOLDABLE ELECTRONIC DEVICE**

(30) Priority: 31.01.2023 CN 202310115371
(71) Applicant: Honor Device Co., Ltd., Shenzhen, Guangdong 518040 (CN)
(72) Inventor: LU, Yilin, Shenzhen, Guangdong 518040 (CN); YAN, Bin, Shenzhen, Guangdong 518040 (CN); ZHANG, Yaolei, Shenzhen, Guangdong 518040 (CN); YU, Dengpan, Shenzhen, Guangdong 518040 (CN)
(74) Representative: Gill Jennings & Every LLP
(86) International application number: PCT/CN2023/137189
(87) International publication number: WO 2024/159918

(57) **Abstract**

This application discloses a sliding mechanism and a foldable electronic device, and relates to the field of mobile terminal technologies. The sliding mechanism is applied to a rotating shaft mechanism of the foldable electronic device, and the rotating shaft mechanism includes a bracket and a sliding mechanism. The sliding mechanism includes a sliding tab and a sliding rail. One end of the sliding tab is rotatably connected to the bracket, and the other end of the sliding tab is slidably connected to the sliding rail. When the sliding tab rotates around the bracket, the sliding rail rotates with the sliding tab and slides along the sliding tab. A plurality of guide plates are disposed on the other end of the sliding tab, and the plurality of guide plates include at least three staggered guide plates, and two adjacent guide plates in the three staggered guide plates are staggered in both a width direction and a thickness direction of the sliding tab. The sliding rail includes a sliding rail body and a plurality of grooves disposed on the sliding rail body, the plurality of grooves include at least three grooves, opening directions of two adjacent grooves in the three grooves are opposite to each other, the groove is configured to accommodate the guide plate, and each of the guide plates is located in one of the grooves.

## Description

This application claims priority to Chinese Patent Application No. 202310115371.3, filed with the China National Intellectual Property Administration on January 31, 2023 and entitled "SLIDING MECHANISM AND FOLDABLE ELECTRONIC DEVICE", which is incorporated herein by reference in its entirety.

### TECHNICAL FIELD

This application relates to the field of mobile terminal technologies, and in particular, to a sliding mechanism and a foldable electronic device.

### BACKGROUND

A rotating shaft is a key component of a foldable-screen device, and a function of the rotating shaft is to implement folding and unfolding of the foldable-screen device. The rotating shaft of the foldable-screen device usually requires a combination of motion such as rotation and sliding to implement final motion of the rotating shaft. Sliding motion is a most common form of motion of the rotating shaft, and a sliding mechanism is widely used in components such as a swing arm and a door plate of the rotating shaft.

With continuous development of the foldable-screen device, an increasingly high thinning requirement is imposed on the foldable-screen device, and continuous thinning requirements also pose a great challenge to a structure of the rotating shaft. In a conventional technology, sliding motion of the sliding mechanism of the rotating shaft is mainly implemented through sliding of a sliding tab in a sliding groove. The sliding groove in the conventional technology usually has a relatively thick thickness. This causes a relatively thick thickness of the entire sliding mechanism, and finally affects a thickness of the foldable-screen device.

### SUMMARY

This application provides a sliding mechanism and a foldable electronic device. The sliding mechanism may be applied to the foldable electronic device. In the sliding mechanism, a plurality of guide blocks are disposed on a sliding tab, and a plurality of grooves are disposed on a sliding rail, so that a staggered structure is formed between the sliding tab and the sliding rail. Therefore, a thickness of a sliding groove can be reduced while sliding stability is ensured, and this helps reduce a thickness of the sliding mechanism, thereby implementing a thinning requirement on the foldable electronic device.

To achieve the foregoing objective, the following technical solutions are used in embodiments of this application.

According to a first aspect, this application provides a sliding mechanism that is applied to a rotating shaft mechanism of a foldable electronic device. The rotating shaft mechanism includes a bracket and a sliding mechanism, and the sliding mechanism is rotatably connected to the bracket. The sliding mechanism includes a sliding tab and a sliding rail. One end of the sliding tab is rotatably connected to the bracket, and the other end of the sliding tab is slidably connected to the sliding rail. When the sliding tab rotates around the bracket, the sliding rail rotates with the sliding tab and slides along the sliding tab. A plurality of guide plates are disposed on the other end of the sliding tab, and the plurality of guide plates include at least three staggered guide plates: a first guide plate, a second guide plate, and a third guide plate, and two adjacent guide plates in the three staggered guide plates are staggered in both a width direction and a thickness direction of the sliding tab. The sliding rail includes a sliding rail body and a plurality of grooves disposed on the sliding rail body, the plurality of grooves include at least three grooves: a first groove, a second groove, and a third groove, opening directions of two adjacent grooves in the three grooves are opposite to each other, the groove is configured to accommodate the guide plate, and each of the guide plates is located in one of the grooves.

On this basis, in the sliding mechanism, a plurality of guide blocks are disposed on the sliding tab, and a plurality of grooves are disposed on the sliding rail, so that a staggered fitting structure is formed between the guide plate on the sliding tab and the groove on the sliding rail. Therefore, a thickness of a sliding groove can be reduced while sliding stability is ensured, and this helps reduce a thickness of the sliding mechanism, thereby reducing a thickness of the foldable electronic device.

In a possible design manner of the first aspect, the plurality of guide plates form a plurality of columns of guide plates in the width direction of the sliding tab, and the plurality of guide plates form two rows of guide plates in the thickness direction of the sliding tab; and the plurality of grooves form a plurality of columns of grooves in a width direction of the sliding rail, and the plurality of grooves form two rows of grooves in a thickness direction of the sliding rail.

In a possible design manner of the first aspect, the first guide plate, the second guide plate, and the third guide plate are three adjacent guide plates in the plurality of guide plates, and the first groove, the second groove, and the third groove are three adjacent grooves in the plurality of grooves.

In a possible design manner of the first aspect, the first guide plate and the second guide plate are two adjacent guide plates in the plurality of guide plates, and the third guide plate is adj acent to neither of the first guide plate and the second guide plate in the plurality of guide plates; and the first groove and the second groove are two adjacent grooves in the plurality of grooves, and the third groove is adjacent to neither of the first groove and the second groove in the plurality of grooves.

In a possible design manner of the first aspect, the first guide plate, the second guide plate, and the third guide plate are three non-adjacent guide plates in the plurality of guide plates; and the first groove, the second groove, and the third groove are three non-adjacent grooves in the plurality of grooves.

In a possible design manner of the first aspect, the first guide plate and the second guide plate are staggered in both the width direction and the thickness direction of the sliding tab, the third guide plate and the second guide plate are staggered in the width direction of the sliding tab, and the third guide plate and the first guide plate are flush with each other in the thickness direction of the sliding tab; an opening direction of the first groove is opposite to an opening direction of the second groove, and the opening direction of the second groove is opposite to an opening direction of the third groove; and the first guide plate is located in the first groove, the second guide plate is located in the second groove, and the third guide plate is located in the third groove.

In a possible design manner of the first aspect, the plurality of guide plates further include a fourth guide plate, and the fourth guide plate is flush with one of the first guide plate, the second guide plate, and the third guide plate; and the plurality of grooves further include a fourth groove, and the fourth guide plate is located in the fourth groove.

In a possible design manner of the first aspect, a reinforcing rib is disposed between any two adjacent guide plates in the plurality of guide plates, and a length of the sliding rail body between any two adjacent grooves in the plurality of grooves is less than lengths of the adjacent grooves to accommodate the reinforcing rib.

In a possible design manner of the first aspect, a thickness of the groove is a sum of a thickness of the guide plate and a sliding gap.

In a possible design manner of the first aspect, the thickness of the guide plate is 0.4~0.6 mm, and the sliding gap is 0.01~0.02 mm.

According to a second aspect, this application provides a foldable electronic device, including a first middle frame, a second middle frame, a foldable screen, and a rotating shaft mechanism. The rotating shaft mechanism includes a bracket, a first sliding mechanism, and a second sliding mechanism, and the first sliding mechanism and the second sliding mechanism are each the sliding mechanism provided in the first aspect and any possible design manner thereof. The first sliding mechanism includes a first sliding tab and a first sliding rail, one end of the first sliding tab is rotatably connected to one end of the bracket, the other end of the first sliding tab is slidably connected to the first sliding rail, and the first middle frame is fixedly connected to the first sliding rail. The second sliding mechanism includes a second sliding tab and a second sliding rail, one end of the second sliding tab is rotatably connected to the other end of the bracket, the other end of the second sliding tab is slidably connected to the second sliding rail, and the second middle frame is fixedly connected to the second sliding rail. Two ends of the foldable screen are respectively connected to the first middle frame and the second middle frame, and a middle part of the foldable screen is bendable.

In a possible design manner of the second aspect, the foldable electronic device further includes a first door plate and a second door plate, both the first door plate and the second door plate are connected to both ends of the bracket by using a door plate rotating mechanism, the door plate rotating mechanism includes a rotating structure and a sliding structure, so that the first door plate and the second door plate are capable of rotating around the bracket; and the first door plate is slidably connected to the first sliding rail by using a first sliding apparatus, and the second door plate is slidably connected to the second sliding rail by using a second sliding apparatus.

In a possible design manner of the second aspect, the first sliding apparatus includes a first slider and a first guide rail, the first guide rail is fixedly connected to the first door plate, the first slider is fixedly connected to the first sliding rail, and the first slider is slidably connected to the first guide rail; and the second sliding apparatus includes a second slider and a second guide rail, the second guide rail is fixedly connected to the second door plate, the second slider is fixedly connected to the second sliding rail, and the second slider is slidably connected to the second guide rail.

It may be understood that for beneficial effects that can be achieved by a wireless charging system provided in the second aspect provided above, refer to the beneficial effects in the first aspect and any possible design manner thereof. Details are not described herein again.

### BRIEF DESCRIPTION OF DRAWINGS

FIG. 1 is a partial sectional view of a folded foldable-screen mobile phone in a conventional technology;
FIG. 2 is a schematic diagram of a structure of fitting between a first sliding rail and a first sliding tab in the foldable-screen mobile phone shown in FIG. 1;
FIG. 3 is a partial sectional view of a foldable electronic device according to an embodiment of this application;
FIG. 4 is a schematic diagram of a partial structure of a sliding mechanism according to an embodiment of this application;
FIG. 5 is a schematic diagram of fitting between a sliding tab and a sliding rail in a sliding mechanism according to an embodiment of this application;
FIG. 6 is a schematic diagram of a partial structure of a sliding mechanism according to an embodiment of this application;
FIG. 7 is a schematic diagram of a partial structure of a sliding mechanism according to an embodiment of this application;
FIG. 8 is a side view of a sliding mechanism according to an embodiment of this application;
FIG. 9 is a diagram of a partial structure of a foldable electronic device according to an embodiment of this application; and
FIG. 10 is a diagram of a partial structure of another foldable electronic device according to an embodiment of this application.

### DESCRIPTION OF EMBODIMENTS

The following describes the technical solutions in this application with reference to the accompanying drawings.

In the embodiments of this application, words such as "example" or "for example" are used to represent giving an example, an illustration, or a description. Any embodiment or design solution described as "example" or "for example" in the embodiments of this application should not be explained as being preferred or advantageous over other embodiments or design solutions. Exactly, use of the words such as "example" or "for example" is intended to present a related concept in a specific manner.

In the embodiments of this application, the terms "first" and "second" are merely used for the purpose of description, and should not be understood as an indication or implication of relative importance or an implicit indication of a quantity of indicated technical features. Therefore, a feature defined with "first" or "second" may explicitly or implicitly include one or more such features.

It should be understood that the terms used in the descriptions of the various examples in this specification are intended for describing specific examples only rather than limiting them. As used in the descriptions of the various examples, singular forms "one" ("a" or "an") and "the" are intended to include plural forms as well, unless otherwise explicitly indicated in the context.

In this application, "at least one" means one, two, or more, and "a plurality of" means two or more. "At least one of the following items" or a similar expression means any combination of these items, including a single item or any combination of a plurality of items. For example, at least one of a, b, or c may represent a, b, c, a-b, a-c, b-c, or a-b-c, where a, b, and c may be singular or plural.

It should be further understood that the term "and/or" used in this specification refers to and covers any of and all possible combinations of one or more associated listed items. The term "and/or" describes an association relationship between associated objects, and indicates that three relationships may exist. For example, "A and/or B" may indicate the following three cases: Only A exists, both A and B exist, and only B exists. In addition, the character "/" in this application usually represents an "or" relationship between associated objects.

It should be further understood that in this application, unless otherwise specified and defined explicitly, the term "connection" should be understood in a broad sense. For example, a "connection" may be a fixed connection, a sliding connection, a detachable connection, or an integral connection; or may be a direct connection, or an indirect connection via an intermediate medium.

It should be further understood that the term "include" (also referred to as "includes", "including", "comprises", and/or "comprising"), when used in the specification, specifies the presence of stated features, integers, steps, operations, elements, and/or components, but does not exclude the presence or addition of one or more other features, integers, steps, operations, elements, components, and/or groups thereof.

It should be understood that "an embodiment", "another embodiment", or "a possible design manner" mentioned throughout the specification means that particular features, structures, or characteristics related to the embodiments or the implementations are included in at least one embodiment of this application. Therefore, "in an embodiment of this application", "in another embodiment of this application", or "in a possible design manner" that occurs everywhere throughout the specification may not necessarily refer to a same embodiment. In addition, these specific features, structures, or characteristics may be combined in one or more embodiments in any appropriate manner.

A foldable electronic device is provided in an embodiment of this application. The electronic device includes electronic products such as a mobile phone with a foldable screen 10, a tablet computer with a foldable screen 10, a notebook computer with a foldable screen 10, and another terminal device with a foldable screen 10. The foldable electronic device includes a rotating shaft mechanism, the rotating shaft mechanism includes a rotating mechanism and a sliding mechanism, and the rotating shaft mechanism is configured to implement folding and unfolding of the foldable electronic device. A specific form of the electronic device is not specially limited in the embodiments of this application. For ease of description, a mobile phone with a foldable screen 10 is used as an example of the foldable electronic device below for description.

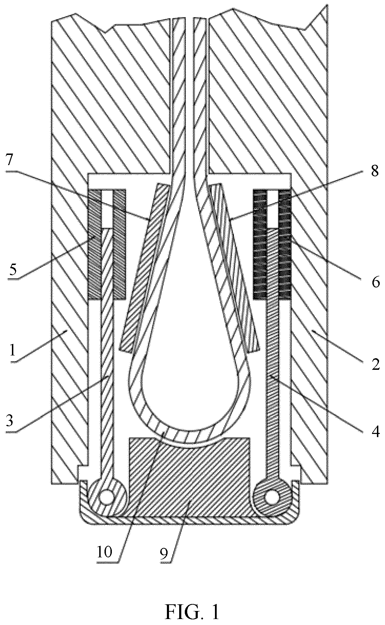

Reference is made to FIG. 1. FIG. 1 is a partial sectional view of a folded mobile phone with a foldable screen 10 in a conventional technology. As shown in FIG. 1, the mobile phone includes a first middle frame 1, a second middle frame 2, a foldable screen 10, door plates, and a rotating shaft mechanism. The rotating shaft mechanism includes a first sliding rail 5, a first sliding tab 3, a second sliding rail 6, a second sliding tab 4, and a bracket 9. The door plates include a first door plate 7 and a second door plate 8. A first end of the first sliding tab 3 and a first end of the second sliding tab 4 are respectively rotatably connected to two ends of the bracket 9, a second end of the first sliding tab 3 is slidably connected to the first sliding rail 5, and the first sliding rail 5 may slide along the first sliding tab 3. A second end of the second sliding tab 4 is slidably connected to the second sliding rail 6, and the second sliding rail 6 may be slidably connected to the second sliding tab 4. The first middle frame 1 is fixedly connected to the first sliding rail 5, and the second middle frame 2 is fixedly connected to the second sliding rail 6. The foldable screen 10 is located between the first middle frame 1 and the second middle frame 2, a part of the foldable screen 10 that is close to the first middle frame 1 is connected to the first middle frame 1, and a part of the foldable screen 10 that is close to the second middle frame 2 is connected to the second middle frame 2. The first door plate 7 is slidably connected to the first sliding rail 5 (not shown in the figure). The first door plate 7 and the first sliding rail 5 may slide relative to each other. The second door plate 8 is slidably connected to the second sliding rail 6 (not shown in the figure). The second door plate 8 and the second sliding rail 6 may slide relative to each other. The first door plate 7 and the second door plate 8 are configured to constrain the foldable screen 10, so that the foldable screen 10 forms a water-drop shape in a folded state.

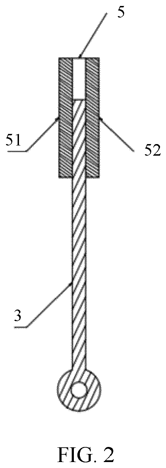

Reference is made to FIG. 2. FIG. 2 is a schematic diagram of a structure in which the first sliding rail 5 fits the first sliding tab 3 in the mobile phone with the foldable screen 10 shown in FIG. 1. As shown in FIG. 2, the first sliding rail 5 includes an upper support wall 51 and a lower support wall 52, and a sliding groove disposed between the upper support wall 51 and the lower support wall 52. The first sliding tab 3 is located in a sliding groove of the first sliding rail 5, and slides in the sliding groove under guidance of the upper support wall 51 and the lower support wall 52. Because the first sliding tab 3 and the first sliding rail 5 need to keep sliding relative to each other, when the first sliding tab 3 is located in the sliding groove of the first sliding rail 5, the first sliding tab 3 needs to keep a small sliding gap with the upper support wall 51 and the lower support wall 52 in the first sliding rail 5 on both sides, to ensure smooth sliding.

As shown in FIG. 2, it is assumed that a thickness of the upper support wall 51 and a thickness of the lower support wall 52 are both M, a thickness of the first sliding tab 3 is L, and a sliding gap between the first sliding tab 3 and the upper support wall 51 and a sliding gap between the first sliding tab 3 and the lower support wall 52 are both a. In this case, an overall thickness of a sliding mechanism including the first sliding tab 3 and the first sliding rail 5 shown in FIG. 2 is 2M+L+2a.

Similarly, the second sliding rail 6 also includes an upper support wall 51, a lower support wall 52, and a sliding groove, and fitting between the second sliding tab 4 and the second sliding rail 6 is the same as fitting between the first sliding tab 3 and the first sliding rail 5. It is assumed that a size and a structure of the second sliding rail 6 are the same as a size and a structure of the first sliding rail 5, and a size of the second sliding tab 4 is the same as a size of the first sliding tab 3. In this case, an overall thickness of a sliding mechanism including the second sliding tab 4 and the second sliding rail 6 is also 2M+L+2a.

It can be learned from FIG. 1 that a thickness of the mobile phone with the foldable screen 10 in a folded state includes: a thickness of a screen and a door plate in the folded state, the thickness of the first sliding tab 3, the thickness of the second sliding tab 4, a distance from the first sliding tab 3 to the first middle frame 1, a distance from the second sliding tab 4 to the second middle frame 2, a thickness of the first middle frame 1, and a thickness of the second middle frame 2.

A main factor that affects the thickness of the screen and the door plate is a bending radius of the screen, and the bending radius of the screen affects a crease and a service life of the screen. Therefore, it is difficult to reduce the bending radius of the screen, that is, currently, it is difficult to significantly reduce the thickness of the screen and the door plate. In the current mobile phone with the foldable screen 10, a thickness of a middle frame (the first middle frame 1 and the second middle frame 2) has been designed to a thickness of a fairly extreme level, and therefore, it is difficult to reduce the thickness of the middle frame. A thickness from the first sliding tab 3 to the first middle frame 1 and a thickness from the second sliding tab 4 to the second middle frame 2 are greatly affected by the thicknesses of the first sliding rail 5 and the thicknesses of the second sliding rail 6. Because the first sliding rail 5 and the second sliding rail 6 include the thicknesses of the upper support wall 51 and the lower support wall 52, a thickness from the sliding tab to the middle frame in the sliding mechanism is affected. Therefore, a thickness of the mobile phone with the foldable screen 10 in the folded state is affected to a relatively large degree, and there is relatively large space for thinning, they are key components for thinning the mobile phone with the foldable screen 10.

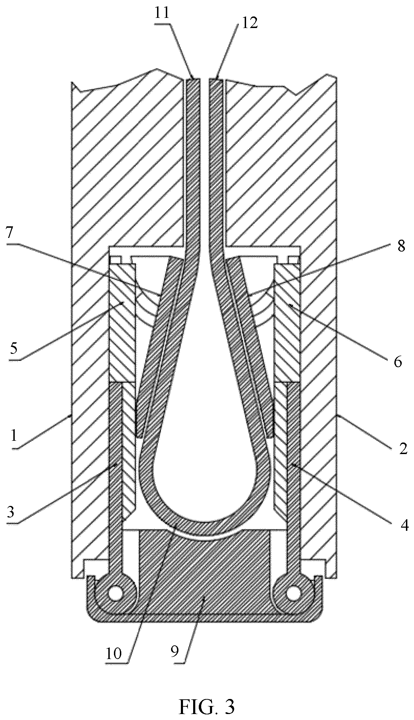

To resolve a problem in the conventional technology that the foldable electronic device has a relatively thick thickness in the folded state because the first sliding rail 5 and the second sliding rail 6 have relatively thick thicknesses, an embodiment of this application provides a sliding mechanism. The sliding mechanism is applied to a rotating shaft mechanism of a foldable electronic device. Compared with the first sliding rail 5 and the second sliding rail 6 in the conventional technology, the sliding mechanism in this embodiment of this application has a relatively thin thickness, so that a thickness of the foldable electronic device in a folded state can be reduced, and a thinning requirement on the foldable electronic device can be implemented. Embodiments of this application are described below in detail with reference to FIG. 3 to FIG. 9.

Reference is made to FIG. 3. FIG. 3 is a partial sectional view of a foldable electronic device according to an embodiment of this application. As shown in FIG. 3, the foldable electronic device includes a first middle frame 1, a second middle frame 2, a foldable screen 10, door plates, and a rotating shaft mechanism. The rotating shaft mechanism includes a sliding mechanism and a bracket 9, and the door plates include a first door plate 7 and a second door plate 8. A middle part of the foldable screen 10 is bendable, and two ends of the foldable screen 10 are respectively connected to the first middle frame 1 and the second middle frame 2. The sliding mechanism includes a first sliding mechanism and a second sliding mechanism, and the first sliding mechanism and the second sliding mechanism are respectively rotatably connected to two ends of the bracket 9. Specifically, the first sliding mechanism may rotate around a first rotating shaft on the bracket 9, and the second sliding mechanism may rotate around a second rotating shaft on the bracket 9.

The first middle frame 1 is connected to the first sliding mechanism, and the second middle frame 2 is connected to the second sliding mechanism. Because the first sliding mechanism is rotatably connected to one end of the bracket 9 by using the first rotating shaft, the second sliding mechanism is rotatably connected to the other end of the bracket 9 by using the second rotating shaft. Therefore, the first middle frame 1 may rotate around the first rotating shaft while sliding along the first sliding mechanism, and the second middle frame 2 may rotate around the second rotating shaft while sliding along the second sliding mechanism. When the first middle frame 1 and the second middle frame 2 rotate, the foldable screen 10 may be driven to rotate, to fold and unfold the foldable screen 10. It should be noted that, that the middle frame may drive the foldable screen 10 to rotate in this embodiment of this application may mean that the first middle frame 1 may drive a side of the foldable screen 10 that is connected to the first middle frame 1 to rotate around a folding line of the foldable screen 10, and the second middle frame 2 may drive a side of the foldable screen 10 that is connected to the second middle frame 2 to rotate around the folding line of the foldable screen 10, to fold and unfold the foldable screen 10, instead of indicating that the entire foldable screen 10 is driven to rotate.

In an embodiment of this application, the first sliding mechanism includes a first sliding rail 5 and a first sliding tab 3, and the second sliding mechanism includes a second sliding rail 6 and a second sliding tab 4. A first end of the first sliding tab 3 and a first end of the second sliding tab 4 are respectively rotatably connected to two ends of the bracket 9. Specifically, the first end of the first sliding tab 3 is rotatably connected to a first end of the bracket 9 by using the first rotating shaft, and the first end of the second sliding tab 4 is rotatably connected to a second end of the bracket 9 by using the second rotating shaft. A second end of the first sliding tab 3 is slidably connected to the first sliding rail 5, and the first sliding rail 5 may slide along the first sliding tab 3. A second end of the second sliding tab 4 is slidably connected to the second sliding rail 6, and the second sliding rail 6 may be slidably connected to the second sliding tab 4. The first middle frame 1 is fixedly connected to the first sliding rail 5, and the second middle frame 2 is fixedly connected to the second sliding rail 6. The first sliding tab 3 is rotatably connected to the bracket 9, and the first sliding tab 3 and the bracket 9 constitute a first rotating mechanism in the rotating shaft mechanism. The second sliding tab 4 is rotatably connected to the bracket 9, and the second sliding tab 4 and the bracket 9 constitute a second rotating mechanism in the rotating shaft mechanism. In other words, in this embodiment of this application, the first sliding tab 3 and the second sliding tab 4 are not only constituent parts of a rotating mechanism, but also constituent parts of a sliding mechanism.

The first sliding tab 3 is rotatably connected to the first end of the bracket 9 by using the first rotating shaft, and the first sliding rail 5 is slidably connected to the first sliding tab 3. Therefore, when the first sliding tab 3 rotates around the first rotating shaft on the bracket 9, the first sliding rail 5 also rotates around the first rotating shaft. In addition, because the first sliding rail 5 may slide along the first sliding tab 3, the first sliding rail 5 may slide along the first sliding tab 3 while rotating around the first rotating shaft. Because the first middle frame 1 is fixedly connected to the first sliding rail 5, motion performed by the first middle frame 1 is also combined motion of two types of motion: rotating around the first rotating shaft, and sliding along the first sliding tab 3. Similarly, because the second sliding tab 4 is rotatably connected to the second end of the bracket 9 by using the second rotating shaft, the second sliding rail 6 is slidably connected to the second sliding tab 4, and the second middle frame 2 is fixedly connected to the second sliding rail 6, motion performed by the second middle frame 2 is combined motion of two types of motion: rotating around the second rotating shaft, and sliding along the second sliding tab 4.

The foldable screen 10 is located between the first middle frame 1 and the second middle frame 2, one fold of the foldable screen 10 that is close to the first middle frame 1 is connected to the first middle frame 1 (not shown in the figure), and one fold of the foldable screen 10 that is close to the second middle frame 2 is connected to the second middle frame 2 (not shown in the figure). It should be noted that one fold of the foldable screen 10 mentioned in this embodiment of this application means a part of the foldable screen 10 that is obtained after the entire foldable screen 10 is equally divided based on the folding line. For example, if the foldable screen 10 needs to be folded only once, one fold of the foldable screen 10 means half of the entire foldable screen 10; and if the foldable screen 10 needs to be folded twice, one fold of the foldable screen 10 means one third of the entire foldable screen 10. As an example for description, the foldable electronic device in this embodiment of this application is folded once. For ease of description, one fold of the foldable screen 10 that is close to the first middle frame 1 is referred to as a first half-screen 11, and one fold of the foldable screen 10 that is close to the second middle frame 2 is referred to as a second half-screen 12.

The first half-screen 11 of the foldable screen 10 is connected to the first middle frame 1, and the second half-screen 12 of the foldable screen 10 is connected to the second middle frame 2. Therefore, when the first middle frame 1 rotates around the first rotating shaft and slides along the first sliding tab 3, the first half-screen 11 may be driven to rotate, and when the second middle frame 2 rotates around the second rotating shaft and slides along the second sliding tab 4, the second half-screen 12 may be driven to rotate. As shown in FIG. 3, the foldable electronic device in FIG. 3 is in the folded state. When the electronic device in the state shown in FIG. 3 needs to be unfolded, the first middle frame 1 may be rotated in a counterclockwise direction, to drive the first half-screen 11 to rotate counterclockwise, and the second middle frame 2 is rotated in a clockwise direction, to drive the second half-screen 12 to rotate clockwise. After the first middle frame 1 is rotated 90° counterclockwise, and the second middle frame 2 is rotated 90° clockwise, the foldable electronic device is in a fully unfolded state, and the foldable screen 10 is also in a fully unfolded state.

In an embodiment of this application, the first sliding mechanism and the second sliding mechanism are usually set to a same structure. When the first sliding mechanism and the second sliding mechanism are mounted in the foldable electronic device, the first sliding mechanism and the second sliding mechanism are usually in a symmetrical state. In this way, symmetry between two half-screens of the foldable electronic device can be ensured. Structures of the first sliding rail 5 and the second sliding rail 6 are described below by using the first sliding rail 5 as an example.

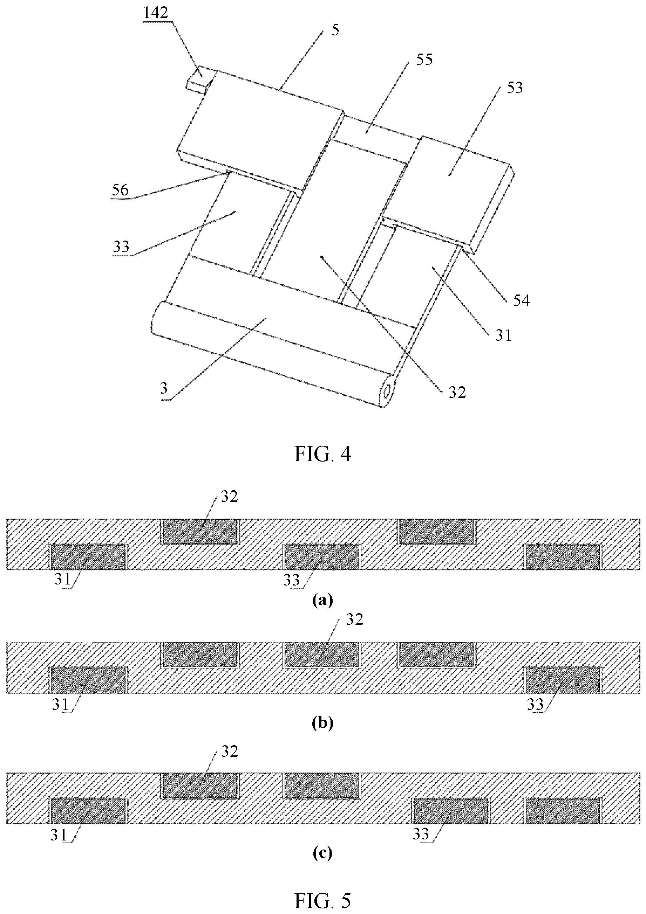

Reference is made to FIG. 4. FIG. 4 is a schematic diagram of a partial structure of a sliding mechanism according to an embodiment of this application. The structure shown in FIG. 4 may be used for both the first sliding mechanism and the second sliding mechanism. As shown in FIG. 4, the sliding mechanism includes a sliding rail and a sliding tab. A plurality of guide plates are disposed at a first end of the sliding tab, the plurality of guide plates include at least three staggered guide plates, and two adjacent guide plates in the three staggered guide plates are staggered in both a width direction and a thickness direction of the sliding tab.

As shown in FIG. 4, the sliding rail includes a sliding rail body 53 and a plurality of grooves disposed on the sliding rail body, the plurality of grooves include at least three grooves, and opening directions of two adjacent grooves in the three grooves are opposite to each other. The groove is configured to accommodate the guide plate, and each of the guide plates is located in one of the grooves. When the sliding rail fits the sliding tab, each guide plate on the sliding tab is placed in a corresponding groove, so that the guide plate may slide in the groove; or the sliding rail may slide along the guide plate, so that the sliding rail and the sliding tab form a sliding mechanism. At least three staggered guide plates are disposed on the sliding tab, and three grooves with opposite opening directions are also correspondingly disposed on the sliding rail. Therefore, when the three guide plates on the sliding tab are respectively inserted into the three grooves on the sliding rail, the guide plates and the grooves restrict each other to restrict a kinematic pair of the sliding tab and the sliding rail, so that the sliding tab and the sliding rail can slide only in a length direction of the guide plate. The presence of an opening on the groove on the sliding rail does not cause detachment between the sliding tab and the sliding rail, or detachment caused by flipping of the sliding tab on the sliding rail does not occur.

It should be noted that the plurality of guide plates include at least three staggered guide plates. The three staggered guide plates may be three adjacent guide plates in the plurality of guide plates, or may be three non-adjacent guide plates in the plurality of guide plates; or two guide plates in the three staggered guide plates are adjacent, and the other guide plate is adjacent to neither of the other two guide plates. The plurality of grooves include at least three grooves. The three grooves may be three adjacent grooves in the plurality of grooves, or may be three non-adjacent grooves in the three grooves; or two grooves in the three grooves are adjacent, and the other groove is adj acent to neither of the other two grooves. In any of the foregoing cases, positions of the three grooves correspond to positions of the three staggered guide plates, to ensure fitting between the sliding tab and the sliding rail. In this embodiment of this application, each guide plate on the sliding tab has one corresponding groove on the sliding rail, to ensure fitting between the sliding tab and the sliding rail.

For example, as shown in FIG. 4, the plurality of guide plates are three guide plates: a first guide plate 31, a second guide plate 32, and a third guide plate 33. The first guide plate 31, the second guide plate 32, and the third guide plate 33 are three adjacent guide plates. The plurality of grooves are three grooves: a first groove 54, a second groove 55, and a third groove 56. The first groove 54, the second groove 55, and the third groove 56 are three adjacent grooves.

Alternatively, reference is made to FIG. 5. FIG. 5 is a schematic diagram of fitting between a sliding tab and a sliding rail in a sliding mechanism according to an embodiment of this application. As shown in FIG. 5, the plurality of guide plates are five guide plates, and the five guide plates include a first guide plate 31, a second guide plate 32, a third guide plate 33, and a fourth guide plate. A disposing position of the first guide plate 31 may be shown in (a) in FIG. 5. In this case, the first guide plate 31, the second guide plate 32, and the third guide plate 33 are three adjacent guide plates in the five guide plates. The plurality of grooves are five grooves, and the five grooves include a first groove 54, a second groove 55, a third groove 56, and a fourth groove. A disposing position of the first groove 54 may be shown in (a) in FIG. 5. In this case, the first groove 54, the second groove 55, and the third groove 56 are three adjacent grooves in the five grooves. The fourth guide plate is flush with one of the first guide plate, the second guide plate, and the third guide plate, and the fourth guide plate is located in the fourth groove. When the fourth groove is flush with the first guide plate 31, an opening direction of the fourth groove is the same as an opening direction of the first groove 54. When the fourth groove is flush with the second guide plate 32, the opening direction of the fourth groove is the same as an opening direction of the second groove 55. When the fourth groove is flush with the third guide plate 33, the opening direction of the fourth groove is the same as an opening direction of the third groove 56.

Disposing positions of the first guide plate 31, the second guide plate 32, and the third guide plate 33 may be shown in (b) in FIG. 5. The first guide plate 31 is the 1^{st} guide plate in the five guide plates, the second guide plate 32 is the 3^{rd} guide plate in the five guide plates, and the third guide plate 33 is the 5^{th} conducting wire block in the five guide plates. In this case, any two of the first guide plate 31, the second guide plate 32, and the third guide plate 33 are non-adjacent guide plates in the five guide plates. To be specific, another guide plate is disposed between the first guide plate 31 and the second guide plate 32, another guide plate is also disposed between the second guide plate 32 and the third guide plate 33, and the first guide plate 31 and the third guide plate 33 are respectively located at two ends and are not adjacent to each other.

Correspondingly, disposing positions of the first groove 54, the second groove 55, and the third groove 56 may be shown in (b) in FIG. 5. The first groove 54 is the 1^{st} groove in the five grooves, the second groove 55 is the 3^{rd} groove in the five grooves, and the third groove 56 is the 5^{th} conducting wire block in the five grooves. In this case, any two of the first groove 54, the second groove 55, and the third groove 56 are non-adjacent grooves in the five grooves. To be specific, another groove is disposed between the first groove 54 and the second groove 55, another groove is also disposed between the second groove 55 and the third groove 56, and the first groove 54 and the third groove 56 are respectively located at two ends and are not adjacent to each other.

The disposing positions of the first guide plate 31, the second guide plate 32, and the third guide plate 33 may be alternatively shown in (c) in FIG. 5. In this case, the first guide plate 31 and the second guide plate 32 are adjacent guide plates in the five guide plates. For example, the first guide plate 31 is the 1^{st} guide plate in the five guide plates, and the second guide plate 32 is the 2^{nd} guide plate in the five guide plates. The third guide plate 33 is adjacent to neither of the first guide plate 31 and the second guide plate 32 in the plurality of guide plates. For example, the third guide plate 33 is the 4^{th} guide plate or the 5^{th} guide plate in the five guide plates. In other words, the first guide plate 31 and the second guide plate 32 are disposed adjacent to each other in the five guide plates, and the third guide plate 33 and the other two guide plates are not adjacent to each other in the plurality of guide plates.

Correspondingly, the disposing positions of the first groove 54, the second groove 55, and the third groove 56 may be alternatively shown in (c) in FIG. 5. In this case, the first groove 54 and the second groove 55 are adjacent grooves in the five grooves. For example, the first groove 54 is the 1^{st} groove in the five grooves, and the second groove 55 is the 2^{nd} groove in the five grooves. The third groove 56 is adjacent to neither of the first groove 54 and the second groove 55 in the plurality of grooves. For example, the third groove 56 is the 4^{th} groove or the 5^{th} groove in the five grooves. In other words, the first groove 54 and the second groove 55 are disposed adjacent to each other in the five grooves, and the third groove 56 and the other two grooves are not adjacent to each other in the plurality of grooves.

It should be noted that the first guide plate 31 corresponds to the first groove 54, and the first guide plate 31 is placed in the first groove 54; the second guide plate 32 corresponds to the second groove 55, and the second guide plate 32 is placed in the second groove 55; and the third guide plate 33 corresponds to the third groove 56, and the third guide plate 33 is placed in the third groove 56.

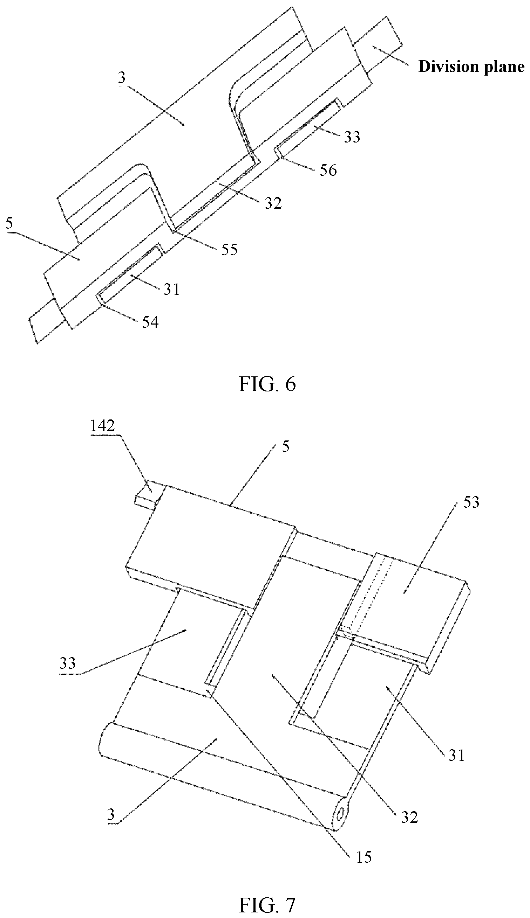

Reference is made to FIG. 6. FIG. 6 is a schematic diagram of a partial structure of a sliding mechanism according to an embodiment of this application. As shown in FIG. 6, in this embodiment of this application, there is a plane between two end surfaces in a thickness direction of the sliding tab. The plane is perpendicular to the thickness direction of the sliding tab, and the plane is located between the two end surfaces in the thickness direction of the sliding tab. The plane is referred to as a segmentation plane. The division plane may divide the sliding tab into two parts.

The plurality of guide plates include a first guide plate 31, a second guide plate 32, and a third guide plate 33. The first guide plate 31 and the third guide plate 33 are located on one side of the division plane, and the second guide plate 32 is located on the other side of the division plane. A projection of the first guide plate 31 on the division plane is referred to as a first projection, a projection of the second guide plate 32 on the division plane is referred to as a second projection, and a projection of the third guide plate 33 on the division plane is referred to as a third projection. The second projection overlaps neither of the first projection and the third projection, and the second projection is located between the first projection and the third projection.

It can be learned from the foregoing descriptions that the first guide plate 31, the second guide plate 32, and the third guide plate 33 are staggered in the width direction of the sliding tab, and the second guide plate 32 is located between the first guide plate 31 and the third guide plate 33 in the width direction of the sliding tab.

In addition, the first guide plate 31 and the second guide plate 32 are staggered in the thickness direction of the sliding tab, and the second guide plate 32 and the third guide plate 33 are also staggered in the thickness direction of the sliding tab. In the thickness direction of the sliding tab, the first guide plate 31 may be flush with the third guide plate 33.

It should be noted that being staggered means that projections of two guide plates or three guide plates on a plane parallel to the width direction of the sliding tab/the thickness direction of the sliding tab do not overlap.

As shown in FIG. 6, one end that is of the sliding tab and on which the guide plate is disposed is in a shape of a cuboid, the division plane is a center plane of the sliding tab in the thickness direction, and the segmentation plane divides the sliding tab into an upper half part and a lower half part. The plurality of guide plates are specifically three guide plates: a first guide plate 31, a second guide plate 32, and a third guide plate 33. The second guide plate 32 is located between the first guide plate 31 and the third guide plate 33. The first guide plate 31 is located in a lower half part of the sliding tab, the second guide plate 32 is located in an upper half part of the sliding tab, and the third guide plate 33 is located in the lower half part of the sliding tab, so that the first guide plate 31, the second guide plate 32, and the third guide plate 33 are staggered in the thickness direction of the sliding tab. In addition, the first guide plate 31, the second guide plate 32, and the third guide plate 33 are spaced apart, so that the first guide plate 31, the second guide plate 32, and the third guide plate 33 are staggered in the width direction of the sliding tab. A thickness of the first guide plate 31, a thickness of the second guide plate 32, and a thickness of the third guide plate 33 may be set to be equal, for example, are each half a thickness of the sliding tab.

During disposing of the sliding rail, a thickness of the sliding rail may be set to be the same as the thickness of the sliding tab, and the division plane also divides the sliding rail into an upper half part and a lower half part in the thickness direction. The plurality of grooves are specifically three grooves: a first groove 54, a second groove 55, and a third groove 56. The second groove 55 is located between the first groove 54 and the third groove 56. The first groove 54 is located in a lower half part of the sliding rail, and an opening faces downward. The second groove 55 is located in an upper half part of the sliding rail, and an opening faces upward. The third groove 56 is located in the lower half part of the sliding rail, and an opening faces downward. An interval between the first groove 54 and the second groove 55 is the same as an interval between the first guide plate 31 and the second guide plate 32, and an interval between the second groove 55 and the third groove 56 is the same as an interval between the second guide plate 32 and the third guide plate 33, so that fitting between the sliding rail and the sliding tab is shown in FIG. 6.

It should be noted that, all guide plates in the plurality of guide plates may be set to have a same size. Correspondingly, the plurality of grooves are also set to have a same size. A size of the groove is determined based on a size of the guide plate, to ensure that the guide plate can slide in the groove. Alternatively, all guide plates in the plurality of guide plates may be set to have different sizes. During disposing of the sliding rail, a specific size of each groove needs to be determined based on a guide plate corresponding to the groove, to ensure that each guide plate can slide in the corresponding groove.

The sliding mechanism in this embodiment of this application is usually applied to a foldable electronic device such as a foldable mobile phone, a foldable tablet computer, and a foldable notebook computer, and a size of the sliding mechanism is relatively small. Generally, in this embodiment of this application, a thickness of the guide plate on the sliding tab is 0.4~0.6 mm, a width of the guide plate is 2~4 mm, a spacing between two adjacent guide plates is 0.6~1 mm, a sliding gap between the guide plate and a groove wall is 0.01~0.02 mm, and an overall width of the sliding tab is usually 12~14 mm. A sliding stroke between the sliding tab and the sliding rail is usually 2~3 mm, and a safety margin between the sliding tab and the sliding rail is usually 1~2 mm. A width and a depth of the groove may be set based on a width and a thickness of the guide plate.

Reference is made to FIG. 7. FIG. 7 is a schematic diagram of a partial structure of a sliding mechanism according to an embodiment of this application. As shown in FIG. 7, a reinforcing rib 15 is disposed between the first guide plate 31 and the second guide plate 32, and the reinforcing rib 15 is also disposed between the second guide plate 32 and the fourth guide plate. When the plurality of guide plates on the sliding tab are more than three guide plates, the reinforcing rib 15 may be disposed between any two adjacent guide plates. Correspondingly, because the reinforcing rib 15 is disposed between two adjacent guide plates, a length of the sliding rail body 53 between two adjacent grooves on the sliding rail is correspondingly reduced, and a reduced length is the same as a length of the reinforcing rib 15. This is because an overall size of the sliding rail is relatively small, and therefore a size of the sliding rail body 53 between two adjacent grooves on the sliding rail is also relatively small. If the length of the sliding rail body 53 between two adjacent grooves on the sliding rail is relatively long, strength of the sliding rail may be affected. However, because the sliding rail fits the sliding tab, if the reinforcing rib 15 is disposed between two adjacent guide plates to reduce a length between two adjacent grooves on the sliding rail, overall strength of the sliding rail is improved, and therefore, strength of the entire sliding mechanism is improved.

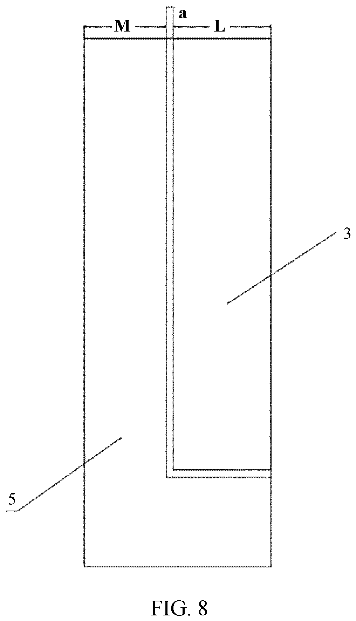

Reference is made to FIG. 8. FIG. 8 is a side view of a sliding mechanism according to an embodiment of this application. As shown in FIG. 8, it is assumed that a thickness of the sliding rail body 53 in the groove is set to M, a thickness of the sliding tab is L, and a sliding gap between the sliding tab and a bottom of the groove is a. In this case, an overall thickness of the sliding mechanism is M+L+a. Compared with a thickness of a sliding mechanism in a conventional technology that is 2M+L+2a, the sliding mechanism in this application reduces a thickness of a sliding structure, and a reduced thickness is M+a. In other words, compared with that in the conventional technology, the sliding mechanism in this embodiment of this application can save a thickness of one support wall and space of one sliding gap, to implement a thinning design of the sliding mechanism. Reference is made to FIG. 3 again. In this application, a thickness of one support wall and space of one sliding gap can be saved. When a position at which the sliding tab and the bracket 9 are connected remains unchanged, this part of saved thickness of a moving mechanism is a spacing between the sliding tab and the middle frame. In other words, through reduction of the thickness of the sliding mechanism, when the position at which the sliding tab and the bracket 9 are connected remains unchanged, the spacing between the middle frame and the sliding tab may be reduced to 0, so that middle frames on both sides of the foldable electronic device in the folded state may be closer to a folded screen, thereby reducing an overall thickness of the foldable electronic device.

In this embodiment of this application, at least three staggered guide plates are disposed on the sliding tab, and grooves corresponding to a quantity of guide plates are disposed on the sliding rail, so that the guide plate on the sliding tab slides in the groove on the sliding rail, to implement sliding fit between the sliding tab and the sliding rail, and in addition, the sliding tab and the sliding rail are not detached in another direction other than a sliding direction, thereby ensuring sliding stability of the sliding mechanism. In a manner of disposing a plurality of guide plates and a plurality of grooves such that each guide plate fits one groove, each groove has only one support wall. In comparison with a conventional sliding rail that needs to be supported by two support walls, the entire sliding mechanism is thinned, so that a thickness of the entire foldable electronic device is reduced.

In this embodiment of this application, as shown in FIG. 3, the door plates include the first door plate 7 and the second door plate 8, and the first door plate 7 and the second door plate 8 are configured to constrain the foldable screen 10, so that the foldable screen 10 forms a water-drop shape in the folded state. The first door plate 7 is connected to the bracket 9 by using a door plate rotating shaft mechanism, and the second door plate 8 is connected to the bracket 9 by using the door plate rotating shaft mechanism.

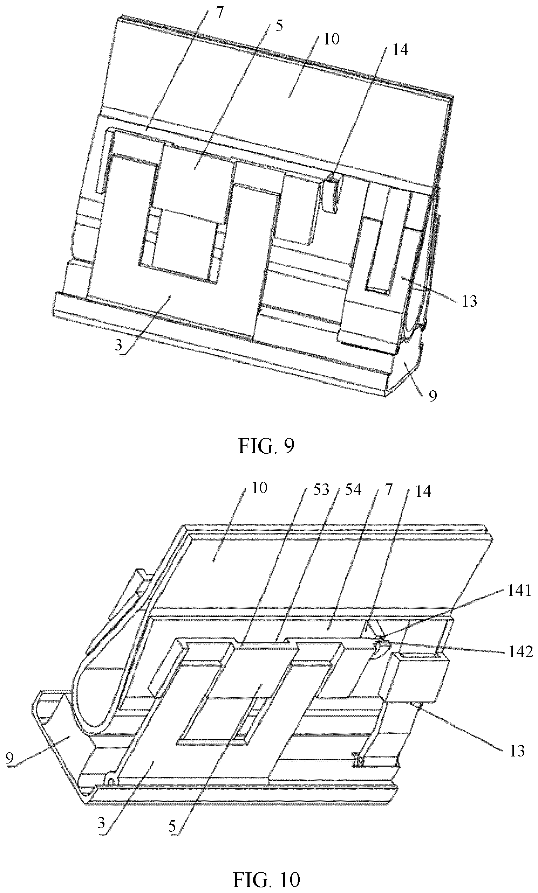

Reference is made to FIG. 9. FIG. 9 is a diagram of a partial structure of a foldable electronic device according to an embodiment of this application. FIG. 9 shows a connection relationship between the door plate and the bracket 9 and a connection relationship between the door plate and the sliding rail in the sliding mechanism, and shows a specific structure of a connection between the door plate and the bracket 9 and a specific structure of a connection between the door plate and the sliding rail in the sliding mechanism.

As shown in FIG. 9, a door plate rotating mechanism 13 also includes a rotating structure and a sliding structure. The sliding structure in the door plate rotating mechanism 13 may be set to a structure of the sliding structure in the foregoing embodiment, and the rotating structure in the door plate rotating mechanism 13 may also be set to a structure of the rotating structure in the foregoing embodiment. A working principle of the door plate rotating mechanism 13 is the same as that of the foregoing rotating shaft mechanism. Therefore, for the working principle of the door plate rotating mechanism 13, reference may be made to the descriptions of the rotating shaft mechanism in the foregoing embodiments. Details are not described herein again.

A difference between the door plate rotating mechanism 13 and the rotating shaft mechanism may lie in different sizes and different connection positions on the bracket 9. Therefore, motion performed by the first door plate 7 is similar to motion performed by the first sliding rail 5, motion performed by the second door plate 8 is similar to motion performed by the second sliding rail 6, and motion performed by the first door plate 7 and the first sliding rail 5 is different from motion performed by the second door plate 8 and the second sliding rail 6. Therefore, motion performed by the first door plate 7 and the second door plate 8 needs to be constrained.

In addition, for the sliding structure in the door plate rotating mechanism 13, reference may be further made to a structure shown in FIG. 10. FIG. 10 is a diagram of a partial structure of another foldable electronic device according to an embodiment of this application. As shown in FIG. 10, the sliding structure in the door plate rotating mechanism 13 includes a sliding tab and a sliding rail. A through hole is disposed on the sliding rail, a shape of the through hole fits a shape of the sliding tab, and the sliding tab is placed in the through hole, so that the sliding rail can slide along the sliding tab.

In this embodiment of this application, the first door plate 7 is further slidably connected to the first sliding rail 5 by using a first sliding apparatus 14, and the second door plate 8 is slidably connected to the second sliding rail 6 by using a second sliding apparatus. The first door plate 7 is configured to constrain the foldable screen 10, so that the foldable screen 10 forms a water-drop shape in the folded state. Unfolding and folding of the foldable screen 10 are mainly affected by the first middle frame 1, and the first middle frame 1 is driven by the first sliding rail 5 to perform motion. Therefore, unfolding and folding of the foldable screen 10 are mainly affected by motion of the first sliding rail 5. Both the first sliding rail 5 and the first door plate 7 rotate around the bracket 9, but the first sliding rail 5 and the first door plate 7 have different rotation centers and different rotation radii. Therefore, the first sliding rail 5 and the first door plate 7 have different rotation paths. The first sliding apparatus 14 is disposed, so that the first door plate 7 slides with the first sliding rail 5 while the first sliding rail 5 and the first door plate 7 rotate around the bracket 9. Similarly, the second sliding apparatus is disposed, so that the second door plate 8 slides with the second sliding rail 6 while the second sliding rail 6 and the second door plate 8 rotate around the bracket 9. The first sliding apparatus 14 is disposed between the first sliding rail 5 and the first door plate 7. After a motion track of the first sliding rail 5 is determined, a motion track of the first door plate 7 can be determined. The second sliding apparatus is disposed between the second sliding rail 6 and the second door plate 8. After a motion track of the second door plate 8 is determined, a motion track of the second door plate 8 can be determined. Structures in this embodiment of this application are usually symmetrically disposed. In other words, the first sliding apparatus 14 and the second sliding apparatus may be of a same structure, and may be symmetrically disposed by using the folding line of the foldable screen 10 as a center. The structures of the first sliding apparatus 14 and the second sliding apparatus are described below by using the first sliding apparatus 14 as an example.

As shown in FIG. 9 or FIG. 10, the first sliding apparatus 14 includes a first slider 142 and a first guide rail 141. The first guide rail 141 is fixedly connected to the first door plate 7, the first slider 142 is fixedly connected to the first sliding rail 5, a sliding groove is disposed on the first guide rail 141, and the first slider 142 is slidably connected to the sliding groove on the first guide rail 141. Because both the first sliding rail 5 and the first door plate 7 perform curvilinear motion, the sliding groove on the first guide rail 141 may be disposed as a curved sliding groove, and a bending direction of the sliding groove is the same as a bending direction of the motion track of the first sliding rail 5, so that both the first sliding rail 5 and the first door plate 7 can normally rotate around the bracket 9. The first slider 142 may be formed integrally with the first sliding rail 5. Due to a relatively small structure, the first slider 142 may alternatively be a rivet. The first sliding rail 5 may be integrally formed with the first door plate 7, or the first sliding rail 5 may be connected to the first door plate 7 through welding.

Similarly, the second sliding apparatus includes a second slider and a second guide rail. The second sliding rail 6 is fixedly connected to the second door plate 8, the second slider is fixedly connected to the second sliding rail 6, a sliding groove is disposed on the second guide rail, and the second slider is slidably connected to the sliding groove on the second guide rail. Because both the second sliding rail 6 and the second door plate 8 perform curvilinear motion, the sliding groove on the second guide rail may be disposed as a curved sliding groove, and a bending direction of the sliding groove is the same as a bending direction of the motion track of the second sliding rail 6, so that both the second sliding rail 6 and the second door plate 8 can normally rotate around the bracket 9. The second slider may be formed integrally with the second sliding rail 6. Due to a relatively small structure, the second slider may also be a rivet. The second sliding rail 6 may be integrally formed with the second door plate 8, or the second sliding rail 6 may be connected to the second door plate 8 through welding.

The foregoing descriptions are merely specific implementations of this application, but are not intended to limit the protection scope of this application. Any person skilled in the art can readily figure out variations or replacements within the technical scope disclosed in this application, and these variations or replacements shall fall within the protection scope of this application.

The embodiments in this specification are described in a progressive manner. Each embodiment focuses on a difference from other embodiments. Refer to the embodiments for same or similar parts in the embodiments.

Although preferred embodiments of the embodiments of this application have been described, a person skilled in the art can make other changes and modifications to these embodiments once they know the basic creative concept. Therefore, the protection scope of this application covers the preferred embodiments and all changes and modifications falling within the scope of the embodiments of this application.

The sliding mechanism and the foldable electronic device provided in this application are described above in detail. Although the principles and implementations of this application are described by using specific examples in this specification, the descriptions of the foregoing embodiments are merely intended to help understand the transmission circuit and the core idea of this application. In addition, a person of ordinary skill in the art may make modifications to the specific implementations and application range according to the idea of this application. In conclusion, the content of this specification should not be construed as a limitation on this application.

The foregoing content is merely specific implementations of this application, but is not intended to limit the protection scope of this application. Any variation or replacement made within the technical scope disclosed in this application shall fall within the protection scope of this application. Therefore, the protection scope of this application shall be subject to the protection scope of the claims.

## Claims

1. A sliding mechanism, applied to a rotating shaft mechanism of a foldable electronic device, wherein the rotating shaft mechanism comprises a bracket and the sliding mechanism, and the sliding mechanism is rotatably connected to the bracket;
the sliding mechanism comprises a sliding tab and a sliding rail, one end of the sliding tab is rotatably connected to the bracket, the other end of the sliding tab is slidably connected to the sliding rail, and when the sliding tab rotates around the bracket, the sliding rail rotates with the sliding tab and slides along the sliding tab;
a plurality of guide plates are disposed on the other end of the sliding tab, and the plurality of guide plates comprise at least three staggered guide plates: a first guide plate, a second guide plate, and a third guide plate, wherein two adjacent guide plates in the three staggered guide plates are staggered in both a width direction and a thickness direction of the sliding tab; and
the sliding rail comprises a sliding rail body and a plurality of grooves disposed on the sliding rail body, the plurality of grooves comprise at least three grooves: a first groove, a second groove, and a third groove, opening directions of two adjacent grooves in the three grooves are opposite to each other, the groove is configured to accommodate the guide plate, and each of the guide plates is located in one of the grooves.

2. The sliding mechanism according to claim 1, wherein the plurality of guide plates form a plurality of columns of guide plates in the width direction of the sliding tab, and the plurality of guide plates form two rows of guide plates in the thickness direction of the sliding tab; and
the plurality of grooves form a plurality of columns of grooves in a width direction of the sliding rail, and the plurality of grooves form two rows of grooves in a thickness direction of the sliding rail.

3. The sliding mechanism according to claim 1 or 2, wherein the first guide plate, the second guide plate, and the third guide plate are three adjacent guide plates in the plurality of guide plates, and the first groove, the second groove, and the third groove are three adjacent grooves in the plurality of grooves.

4. The sliding mechanism according to claim 1 or 2, wherein the first guide plate and the second guide plate are two adjacent guide plates in the plurality of guide plates, and the third guide plate is adjacent to neither of the first guide plate and the second guide plate in the plurality of guide plates; and
the first groove and the second groove are two adjacent grooves in the plurality of grooves, and the third groove is adjacent to neither of the first groove and the second groove in the plurality of grooves.

5. The sliding mechanism according to claim 1 or 2, wherein the first guide plate, the second guide plate, and the third guide plate are three non-adjacent guide plates in the plurality of guide plates; and
the first groove, the second groove, and the third groove are three non-adjacent grooves in the plurality of grooves.

6. The sliding mechanism according to any one of claims 3 to 5, wherein the first guide plate and the second guide plate are staggered in both the width direction and the thickness direction of the sliding tab, the third guide plate and the second guide plate are staggered in the width direction of the sliding tab, and the third guide plate and the first guide plate are flush with each other in the thickness direction of the sliding tab;
an opening direction of the first groove is opposite to an opening direction of the second groove, and the opening direction of the second groove is opposite to an opening direction of the third groove; and
the first guide plate is located in the first groove, the second guide plate is located in the second groove, and the third guide plate is located in the third groove.

7. The sliding mechanism according to claim 2, wherein the plurality of guide plates further comprise a fourth guide plate, and the fourth guide plate is flush with one of the first guide plate, the second guide plate, and the third guide plate; and
the plurality of grooves further comprise a fourth groove, and the fourth guide plate is located in the fourth groove.

8. The sliding mechanism according to any one of claims 1 to 7, wherein a reinforcing rib is disposed between any two adjacent guide plates in the plurality of guide plates, and a length of the sliding rail body between any two adjacent grooves in the plurality of grooves is less than lengths of the adjacent grooves to accommodate the reinforcing rib.

9. The sliding mechanism according to any one of claims 1 to 8, wherein a thickness of the groove is a sum of a thickness of the guide plate and a sliding gap.

10. The sliding mechanism according to claim 9, wherein the thickness of the guide plate is 0.4~0.6 mm, and the sliding gap is 0.01~0.02 mm.

11. A foldable electronic device, comprising a first middle frame, a second middle frame, a foldable screen, and a rotating shaft mechanism, wherein the rotating shaft mechanism comprises a bracket, a first sliding mechanism, and a second sliding mechanism, and the first sliding mechanism and the second sliding mechanism are each the sliding mechanism according to any one of claims 1 to 10;
the first sliding mechanism comprises a first sliding tab and a first sliding rail, one end of the first sliding tab is rotatably connected to one end of the bracket, the other end of the first sliding tab is slidably connected to the first sliding rail, and the first middle frame is fixedly connected to the first sliding rail;
the second sliding mechanism comprises a second sliding tab and a second sliding rail, one end of the second sliding tab is rotatably connected to the other end of the bracket, the other end of the second sliding tab is slidably connected to the second sliding rail, and the second middle frame is fixedly connected to the second sliding rail; and
two ends of the foldable screen are respectively connected to the first middle frame and the second middle frame, and a middle part of the foldable screen is bendable.

12. The foldable electronic device according to claim 11, further comprising a first door plate and a second door plate, wherein both the first door plate and the second door plate are connected to both ends of the bracket by using a door plate rotating mechanism, the door plate rotating mechanism comprises a rotating structure and a sliding structure, so that the first door plate and the second door plate are capable of rotating around the bracket; and
the first door plate is slidably connected to the first sliding rail by using a first sliding apparatus, and the second door plate is slidably connected to the second sliding rail by using a second sliding apparatus.

13. The foldable electronic device according to claim 12, wherein the first sliding apparatus comprises a first slider and a first guide rail, wherein the first guide rail is fixedly connected to the first door plate, the first slider is fixedly connected to the first sliding rail, and the first slider is slidably connected to the first guide rail; and
the second sliding apparatus comprises a second slider and a second guide rail, the second guide rail is fixedly connected to the second door plate, the second slider is fixedly connected to the second sliding rail, and the second slider is slidably connected to the second guide rail.
